# EUROPÄISCHE PATENTSCHRIFT

(11) **EP 1 233 461 B1**
(45) Veröffentlichungstag und Bekanntmachung des Hinweises auf die Patenterteilung: **21.06.2006**
(21) Anmeldenummer: 02002855.1
(22) Anmeldetag: 08.02.2002
(51) Int. Cl.: H01L 41/083

(54) **Piezokeramischer Vielschichtaktor mit einem Übergangsbereich zwischen dem aktiven Bereich und dem inaktiven Kopf- und Fussbereich**
Piezoceramic multilayer actuator having a transition zone between the active zone and the inactive head and foot zone
Actionneur multicouche piézocéramique avec une zone transitoire entre la zone active et la zone inactive de tête et de pied

(30) Priorität: 15.02.2001 DE 10107504; 24.01.2002 DE 10202574
(43) Veröffentlichungstag der Anmeldung: 21.08.2002
(73) Patentinhaber: Ceram Tec Ag Innovative Ceramic Engineering, 73207 Plochingen (DE)
(72) Erfinder: Bindig, Reiner, 95463 Bindlach (DE); Helke, Günter, Dr., 91207 Lauf (DE); Schmidt, Jürgen, 95615 Marktredwitz (DE); Schreiner, Hans-Jürgen, Dr., 91233 Neunkirchen am Sand-Rollhofen (DE); Simmerl, Matthias, 91239 Henfenfeld (DE)
(74) Vertreter: Uppena, Franz

(56) Entgegenhaltungen:
- EP-A- 1 160 886
- WO-A-00/35027
- PATENT ABSTRACTS OF JAPAN Bd. 2000, Nr. 03, 30. März 2000 (2000-03-30) & JP 11 340535 A (KYOCERA CORP), 10. Dezember 1999 (1999-12-10)
- PATENT ABSTRACTS OF JAPAN Bd. 017, Nr. 071 (E-1319), 12. Februar 1993 (1993-02-12) & JP 04 274377 A (NEC CORP), 30. September 1992 (1992-09-30)
- PATENT ABSTRACTS OF JAPAN Bd. 017, Nr. 039 (E-1311), 25. Januar 1993 (1993-01-25) & JP 04 256381 A (NEC CORP), 11. September 1992 (1992-09-11)

## Beschreibung

Die Erfindung betrifft einen piezokeramischen Vielschichtaktor entsprechend dem Oberbegriff des ersten Anspruchs.

Vielschichtaktoren aus piezokeramischen Werkstoffen weisen eine wechselseitige Kontaktierung auf, das heißt, die Innenelektroden werden alternierend an die Oberfläche der sich gegenüberliegenden Seiten des Aktors geführt und dort jeweils durch eine Aussenelektrode elektrisch parallel geschaltet. Zur elektrischen Isolierung bestehen der Kopfbereich und der Fußbereich aus inaktiven, das heißt elektrodenfreien Lagen aus Piezokeramik.

Durch die Anordnung der metallischen Elektroden und der Lagen des piezokeramischen Werkstoffs wird die Schwindung des piezokeramischen Werkstoffes, insbesondere im passiven Kopf- und Fußbereich, während des Sinterprozesses beeinflusst. Schwindungsdifferenzen zwischen elektrodennahen und elektrodenfernen Bereichen führen zu Spannungen im keramischen Werkstoff, die entweder schon während des Sinterprozesses zu Rissen führen oder im fertigen Bauteil festigkeitsmindernd wirken. Dadurch vergrößert sich bei diesen Bauteilen die Anfälligkeit zur Rissbildung während des Betriebes deutlich. Unterschiedliche Dehnungsverhalten des aktiven und des passiven Bereichs während des Betriebs führen insbesondere an der Grenze zwischen beiden Bereichen zu Spannungen, die die Rissbildung begünstigen. Risse können für einige Anwendungen toleriert werden Es ergeben sich jedoch grundsätzliche Probleme. Wenn der Aktor nicht vollständig gekapselt ist, treten an den durch die Risse freigelegten Elektrodenenden elektrische Felder auf, die zur Anlagerung von Wasser oder anderen polaren Molekülen führen können. Diese verursachen Leckströme oder führen zu einer verstärkten Degradation des Aktorverhaltens. Es ist außerdem nicht vollständig auszuschließen, dass die Aktoren, durch die Risse vorgeschädigt, aufgrund von Ausbrüchen während des Betriebs versagen.

Ein piezoelektrisches Vielschichtaktor ist in WO 00/35 027 offenbart.

Aufgabe der Erfindung ist es, die Ursachen für das Auftreten von rissbildenden Spannungen weitestgehend zu beseitigen.

Die Lösung der Aufgabe erfolgt mit Hilfe der kennzeichnenden Merkmale des ersten Anspruchs. Weitere vorteilhafte Ausgestaltungen der Erfindung werden in den Unteransprüchen beansprucht.

Erfindungsgemäß ist jeweils zwischen dem aktiven Bereich und dem inaktiven Kopfbereich und Fußbereich ein Übergangsbereich zwischengeschaltet, dessen Schwindung während der Herstellung und dessen Dehnungsverhalten während des Betriebs zwischen der Schwindung beziehungsweise Dehnungsverhalten des aktiven und der Schwindung beziehungsweise dem Dehnungsverhalten der piezoelektrisch inaktiven Bereiche liegt. Dieser Übergangsbereich kann durch zwei Maßnahmen geschaffen werden. Entweder wird im Übergangsbereich der Abstand zwischen den Innenelektroden zu den Enden des Aktors hin von Elektrode zu Elektrode vergrößert oder der Werkstoff des Übergangsbereichs besteht aus einem piezokeramischen Werkstoff, dessen Schwindung und Dehnungsverhalten zwischen den Eigenschaften des aktiven und den Eigenschaften des passiven Bereichs liegt. Die Eigenschaften des Werkstoffs im Übergangsbereich, insbesondere sein Sinterverhalten, können durch eine Dotierung mit Fremdatomen beeinflusst werden. Dazu eignen sich die Werkstoffe der Innenelektroden. Die Dotierung kann in einer Konzentration erfolgen, die sich im aktiven Bereich an der Grenze zwischen einer Innenelektrode und dem keramischen Werkstoff durch natürliche Diffusion einstellt. Eine Dotierung kann beispielsweise mit Silber erfolgen, das ein Werkstoff der Innenelektroden ist.

Durch die Vergrößerung der Abstände der Innenelektroden im Übergangsbereich wird erfindungsgemäß bewirkt, dass bei der Herstellung eines Vielschichtaktors die unterschiedliche Schwindung zwischen dem aktiven und dem inaktiven Bereich nicht abrupt erfolgt und dadurch der Aufbau von Spannungen bis zur verursachenden Größe der Rissbildung vermieden wird. Während des Betriebs des Aktors wird beim Anlegen der Betriebsspannung die Feldstärke im Übergangsbereich entsprechend der Vergrößerung des Elektrodenabstands stufenweise bis auf Null reduziert. Die durch die unterschiedliche Dehnung vom aktiven und dem sich anschließenden inaktiven Bereich ansonsten entstehenden Spannungen werden durch den Übergangsbereich auf ein deutlich größeres Bauteilvolumen verteilt. Dadurch wird verhindert, dass die Spannungen eine die Rissbildung auslösende kritische Größe erreichen. Die Vergrößerung der Abstände zwischen den Elektroden im Zwischenbereich kann dadurch erzeugt werden, dass zwischen den Elektroden in der dem gewünschten Abstand entsprechender Anzahl Folien aus piezokeramischem Werkstoff aufeinandergelegt werden, die nicht mit Elektroden bedruckt sind.

Es gibt unterschiedliche Möglichkeiten, im Übergansbereich den Abstand von Innenelektrode zu Innenelektrode zu vergrößern. Der Abstand kann in Schritten der Folge der natürlichen Zahlen vergrößert sein. Beträgt der Abstand der Elektroden im aktiven Bereich beispielsweise 100 µm, was in der Regel der Dicke einer Schicht aus einem piezokeramischen Werkstoff mit der Schicht des metallischen Werkstoffs der Elektrode entspricht, so vergrößert sich der Abstand in dem Übergangsbereich in den Schritten 200 µm, 300 µm, 400 µm usw..

In einer weiteren Ausgestaltung der Erfindung kann im Übergangsbereich der Abstand von Elektrode zu Elektrode auch in Schritten einer geometrischen Reihe vergrößert sein. Ebenfalls ausgehend von einem Abstand der Innenelektroden von 100 µm vergrößert sich der Abstand hier in den Schritten 200 µm, 400 µm, 800 µm usw..

Weiterhin kann im Übergangsbereich der Abstand der Innenelektroden in Schritten einer logarithmischen Skalierung erfolgen.

Anhand von Ausführungsbeispielen wird die Erfindung näher erläutert. Es zeigen:
- Figur 1: einen erfindungsgemäßen Vielschichtaktor, dessen Übergangsbereich durch Vergrößerung des Abstands zwischen den Elektroden gebildet wird und
- Figur 2: einen erfindungsgemäßen Vielschichtaktor, dessen Übergangsbereich durch einen piezokeramischen Werkstoff gebildet wird, dessen Schwindung und Dehnungsverhalten zwischen den Eigenschaften des aktiven und den Eigenschaften des passiven Bereichs liegt.

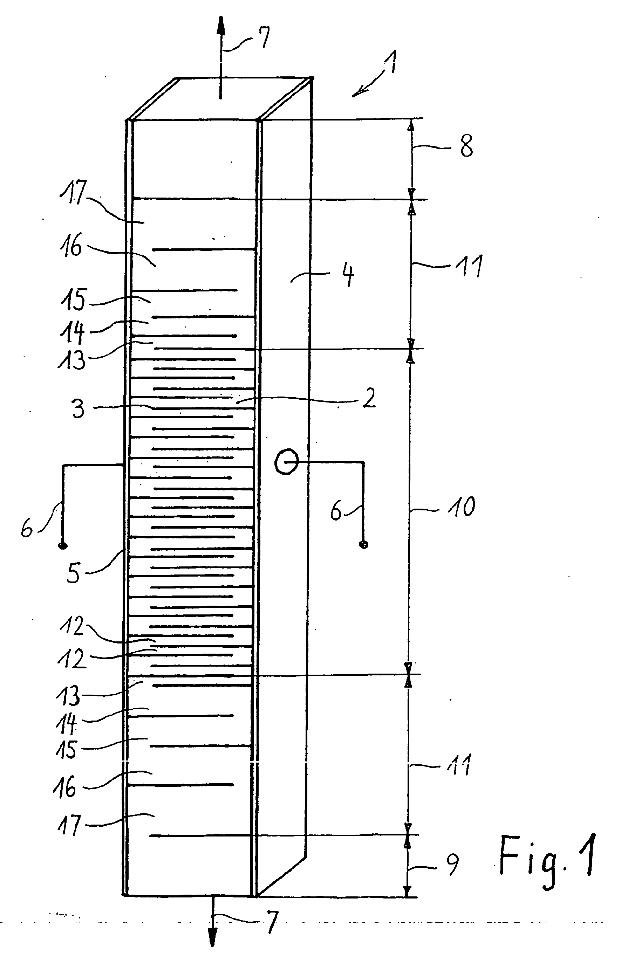

In Figur 1 ist ein erfindungsgemäßer piezokeramischer Vielschichtaktor 1 stark vergrößert schematisch dargestellt. Der Aktor weist eine wechselseitige Kontaktierung auf. Er ist als Monolith hergestellt worden, das heißt, er besteht aus gestapelten dünnen Schichten 2 piezoelektrisch aktiven Werkstoffs, beispielsweise Blei-Zirkonat-Titanat (PZT), mit dazwischen angeordneten leitfähigen Innenelektroden 3. Vor dem Sintern werden auf die piezoelektrisch aktiven Schichten 2, auf die sogenannten Grün-Folien, durch ein Siebdruckverfahren die Innenelektroden 3 aufgedruckt, die Folien 2 mit den Innenelektroden 3 zu einem Stapel verpresst, pyrolysiert und dann gesintert, wodurch ein monolithischer Vielschichtaktor 1 entsteht.

Die Innenelektroden 3 werden alternierend an die sich gegenüberliegenden Aktoroberflächen geführt, wo sie jeweils durch eine Außenelektrode 4, 5 miteinander verbunden werden. Dadurch werden die Innenelektroden 3 jeweils auf einer Seite des Aktors 1 elektrisch parallel geschaltet und so zu einer Gruppe zusammengefasst. Die Außenelektroden 4, 5 sind die Anschlusspole des Aktors. Wird über die Anschlüsse 6 eine elektrische Spannung an die Anschlusspole gelegt, so wird diese auf alle Innenelektroden 3 parallel übertragen und verursacht ein elektrisches Feld in allen Schichten 2 des aktiven Materials, das sich dadurch mechanisch verformt. Die Summe aller dieser mechanischen Verformungen steht an den Endflächen des Aktors 1 als nutzbare Dehnung 7 und/oder Kraft zur Verfügung.

Ein herkömmlicher Vielschichtaktor besteht aus dem inaktiven Kopfbereich 8 und dem inaktiven Fußbereich 9, in denen keine Innenelektroden angeordnet sind, und dem aktiven Bereich 10 mit den Innenelektroden 3. Bei dem erfindungsgemäßen Vielschichtaktor 1 ist jeweils zwischen dem elektrodenfreien Kopfbereich 8 sowie dem elektrodenfreien Fußbereich 9 und dem aktiven Bereich 10 ein Übergangsbereich 11 angeordnet. Während der Abstand 12 der Innenelektroden 3 im aktiven Bereich 10 konstant gleich groß ist, vergrößert er sich innerhalb der Übergangsbereiche 11 von Elektrode zu Elektrode zum Kopfbereich 8 beziehungsweise Fußbereich 9 hin. Im vorliegenden Ausführungsbeispiel vergrößern sich die Abstände, ausgehend vom Abstand 12 der Innenelektroden 3 im aktiven Bereich 10, in Schritten der Folge natürlicher Zahlen. Der Abstand 13 entspricht noch dem Abstand 12 im aktiven Bereich 10 und damit der Dicke einer Folie oder Schicht 2 piezoelektrisch aktiven Werkstoffs im gesinterten Zustand. Der Abstand 14 ist doppelt so groß wie der Abstand 13 oder der Abstand 12, der Abstand 15 ist um das Dreifache, der Abstand 16 um das Vierfache und der Abstand 17 um das Fünffache größer als der Abstand 13. Die Abstandsvergrößerung kann dadurch erzielt werden, dass entsprechend der Abstandsvergrößerung eine darauf abgestimmte Anzahl von Lagen 2 aufeinandergelegt wird.

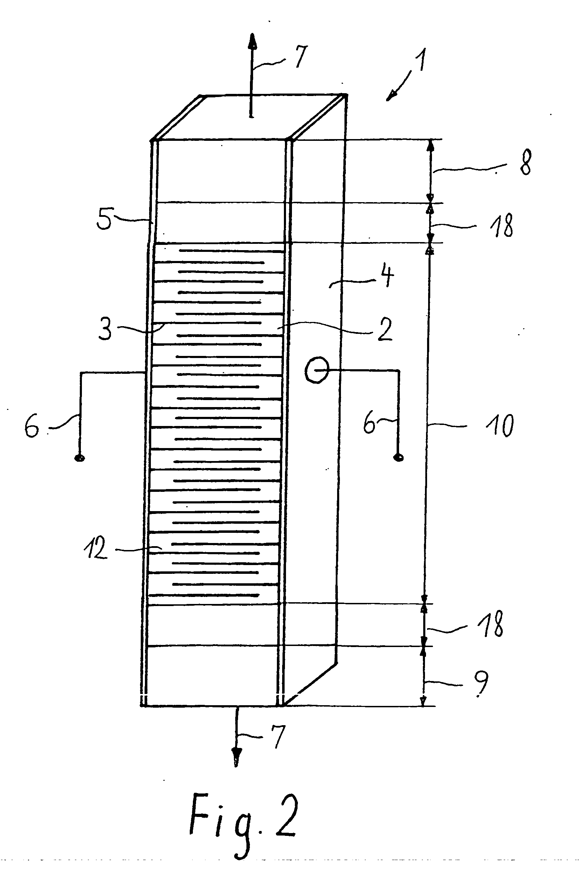

Das Ausführungsbeispiel nach Figur 2 unterscheidet sich von dem Ausführungsbeispiel nach Figur 1 nur durch den Übergangsbereich, hier mit 18 bezeichnet. Mit dem vorhergehenden Ausführungsbeispiel übereinstimmende Merkmale sind mit denselben Bezugsziffem bezeichnet. Der Übergangsbereich 18 besteht aus einem piezokeramischen Werkstoff, dessen Schwindung und Dehnungsverhalten zwischen den Eigenschaften des aktiven und den Eigenschaften des passiven Bereichs liegt. Er ist beispielsweise mit Silber, einem Werkstoff der Innenelektroden, in einer Konzentration dotiert, die sich im aktiven Bereich an der Grenze zwischen einer innenelektrode und dem keramischen Werkstoff durch natürliche Diffusion einstellt.

## Patentansprüche

1. Piezokeramischer Vielschichtaktor (1) mit alternierend an die Aktoroberfläche geführten Innenelektroden (3), wobei die gleich gepolten Innenelektroden (3) des aktiven Bereichs (10) zur Parallelschaltung an die jeweilige Aussenelektrode (4, 5) angeschlossen sind, die Aussenelektroden (4, 5) auf sich gegenüberliegenden Seiten des Aktors (1) angeordnet sind und der Kopfbereich (8) und der Fußbereich (9) piezoelektrisch inaktiv sind, **dadurch gekennzeichnet, dass** sich an den aktiven Bereich (10) jeweils zum inaktiven Kopfbereich (8) und inaktiven Fußbereich (9) hin ein Übergangsbereich (11, 18) anschließt, dessen Schwindung und dessen Dehnverhalten zwischen der Schwindung und dem Dehnverhalten des aktiven (10) und der Schwindung und dem Dehnverhalten eines inaktiven Bereichs (8, 9) liegt, der frei von Elektroden ist.

2. Piezokeramischer Vielschichtaktor nach Anspruch 1, **dadurch gekennzeichnet, dass** im Übergangsbereich (11) zwischen dem aktiven Bereich (10) und dem inaktiven Kopfbereich (8) und dem inaktiven Fußbereich (9) der Abstand (12, 13, 14, 15, 16, 17) zwischen den Innenelektroden (3) zum Kopf- (8) oder Fußbereich (9) des Aktors (1) hin von Elektrode zu Elektrode vergrößert ist.

3. Piezokeramischer Vielschichtaktor nach Anspruch 1 oder 2, **dadurch gekennzeichnet, dass** die Vergrößerung des Abstands (12, 13, 14, 15, 16, 17) der Innenelektroden (3) im Übergangsbereich (11) zum Kopf- (8) oder Fußbereich (9) des Aktors (1) hin, ausgehend vom Abstand (12) der Innenelektroden (3) im aktiven Bereich (10), in Schritten der Folge der natürlichen Zahlen erfolgt.

4. Piezokeramischer Vielschichtaktor nach Anspruch 1 oder 2, **dadurch gekennzeichnet, dass** die Vergrößerung des Abstands der Innenelektroden (3) im Übergangsbereich (11) zum Kopf- (8) oder Fußbereich (9) des Aktors (1) hin, ausgehend vom Abstand (12) der Innenelektroden (3) im aktiven Bereich (10), in Schritten einer geometrischen Reihe erfolgt.

5. Piezokeramischer Vielschichtaktor nach Anspruch 1 oder 2, **dadurch gekennzeichnet, dass** die Vergrößerung des Abstands der Innenelektroden (3) im Übergangsbereich (11) zum Kopf- (8) oder Fußbereich (9) des Aktors (1) hin, ausgehend vom Abstand (12) der Innenelektroden (3) im aktiven Bereich (10), in Schritten einer logarithmischen Skalierung erfolgt.

6. Piezokeramischer Vielschichtaktor nach einem der Ansprüche 1 bis 5, **dadurch gekennzeichnet, dass** die Anzahl der Schritte zur Vergrößerung des Abstands (12, 13, 14, 15, 16, 17) zwischen den Elektroden (3) dem Unterschied der Schwindung und des Dehnverhaltens zwischen dem aktiven (10) und dem angrenzenden passiven Bereich (8, 9) angepasst ist.

7. Piezokeramischer Vielschichtaktor nach einem der Ansprüche 1 bis 5, **dadurch gekennzeichnet, dass** der größte Abstand (17) zwischen den beiden letzten Elektroden (3) im Übergangsbereich (11) bis zu 2 mm beträgt.

8. Piezokeramischer Vielschichtaktor nach Anspruch 6, **dadurch gekennzeichnet, dass** der größte Abstand (17) zwischen den beiden letzten Elektroden (3) im Übergangsbereich (11) etwa zwischen 0,1 mm und 1 mm liegt.

9. Piezokeramischer Vielschichtaktor nach Anspruch 1, **dadurch gekennzeichnet, dass** der jeweilige Übergangsbereich (18) zwischen dem inaktiven Kopfbereich (8) und dem inaktiven Fußbereich (9) aus einem modifizierten piezokeramischen Werkstoff besteht, dessen Schwindung und dessen Dehnverhalten zwischen der Schwindung und dem Dehnverhalten des aktiven Bereichs (10) und der Schwindung und dem Dehnverhalten desinaktiven Kopfbereichs (8) beziehungsweise des inaktiven Fußbereichs (9) liegen.

10. Piezokeramischer Vielschichtaktor nach Anspruch 9, **dadurch gekennzeichnet, dass** die Eigenschaften des Werkstoffs im Übergangsbereich (11), insbesondere sein Sinterverhalten, durch eine Dotierung mit Fremdatomen der Werkstoffe der Innenelektroden (3) beeinflussbar sind.

11. Piezokeramischer Vielschichtaktor nach Anspruch 10, **dadurch gekennzeichnet, dass** die Dotierung des Werkstoffs im Übergangsbereich (11) in einer Konzentration besteht, die sich im aktiven Bereich (10) an der Grenze zwischen einer Innenelektrode (3) und dem keramischen Werkstoff (2) durch natürliche Diffusion einstellt.

12. Piezokeramischer Vielschichtaktor nach Anspruch 10 oder 11, **dadurch gekennzeichnet, dass** die Dotierung des Werkstoffs im Übergangsbereich (11) mit Silber erfolgt ist.

## Claims

1. Piezoceramic multilayer actuator (1) with inner electrodes (3) led out alternately to the actuator surface, wherein, for parallel connection, the inner electrodes (3) of identical polarity of the active region (10) are connected to the respective outer electrode (4, 5), the outer electrodes (4, 5) are disposed on opposite sides of the actuator (1), and the head region (8) and the foot region (9) are piezoelectrically inactive, **characterised in that** a transition region (11, 18), whose shrinkage and whose expansion behaviour lie between the shrinkage and the expansion behaviour of the active region (10) and the shrinkage and the expansion behaviour of an inactive region (8, 9) that is electrode-free, adjoins the active region (10) up to the inactive head region (8) and up to the inactive foot region (9), respectively.

2. Piezoceramic multilayer actuator according to claim 1, **characterised in that** in the transition region (11) between the active region (10) and the inactive head region (8) and the inactive foot region (9), the electrode-to-electrode spacing (12, 13, 14, 15, 16, 17) between the inner electrodes (3) increases up to the head region (8) or foot region (9) of the actuator (1).

3. Piezoceramic multilayer actuator according to claim 1 or 2, **characterised in that** the increase in the spacing (12, 13, 14, 15, 16, 17) of the inner electrodes (3) in the transition region (11) up to the head region (8) or foot region (9) of the actuator (1), starting from the spacing (12) of the inner electrodes (3) in the active region (10), is effected stepwise as a sequence of natural numbers.

4. Piezoceramic multilayer actuator according to claim 1 or 2, **characterised in that** the increase in the spacing of the inner electrodes (3) in the transition region (11) up to the head region (8) or the foot region (9) of the actuator (1), starting from the spacing (12) of the inner electrodes (3) in the active region (10), is effected stepwise in a geometric progression.

5. Piezoceramic multilayer actuator according to claim 1 or 2, **characterised in that** the increase in the spacing of the inner electrodes (3) in the transition region (11) up to the head region (8) or the foot region (9) of the actuator (1), starting from the spacing (12) of the inner electrodes (3) in the active region (10), is effected stepwise according to a logarithmic scale.

6. Piezoceramic multilayer actuator according to one of claims 1 to 5, **characterised in that** the number of steps for increasing the spacing (12, 13, 14, 15, 16, 17) between the electrodes (3) is matched to the difference in the shrinkage and expansion behaviour between the active region (10) and the adjacent passive region (8, 9).

7. Piezoceramic multilayer actuator according to one of claims 1 to 5, **characterised in that** the maximum spacing (17) between the last two electrodes (3) in the transition region (11) is up to 2 mm.

8. Piezoceramic multilayer actuator according to claim 6, **characterised in that** the maximum spacing (17) between the last two electrodes (3) in the transition region (11) lies approximately between 0.1 mm and 1 mm.

9. Piezoceramic multilayer actuator according to claim 1, **characterised in that** the respective transition region (18) between the inactive head region (8) and the inactive foot region (9) consists of a modified piezoceramic material, whose shrinkage and whose expansion behaviour lie between the shrinkage and the expansion behaviour of the active region (10) and, respectively, the shrinkage and the expansion behaviour of the inactive head region (8) and the shrinkage and the expansion behaviour of the inactive foot region (9).

10. Piezoceramic multilayer actuator according to claim 9, **characterised in that** the properties of the material in the transition region (11), in particular its sintering behaviour, can be influenced by doping with impurity atoms of the materials of the inner electrodes (3).

11. Piezoceramic multilayer actuator according to claim 10, **characterised in that** the doping of the material in the transition region (11) is in a concentration that is produced by natural diffusion in the active region (10) at the boundary between an inner electrode (3) and the ceramic material (2).

12. Piezoceramic multilayer actuator according to claim 10 or 11, **characterised in that** the doping of the material in the transition region (11) is effected with silver.

## Revendications

1. Actionneur multicouche piézocéramique (1) avec des électrodes internes (3) aboutissant alternativement à la surface de l'actionneur, les électrodes de même polarité de la zone active (10) étant raccordées en parallèle à l'électrode externe (4, 5) correspondante, ces électrodes externes étant montés sur les côtés opposés de l'actionneur, tandis que la zone de tête (8) et la zone de pied (9) sont piézoélectriquement inactives, **caractérisé en ce qu'**à la zone active (10) fait suite, en direction de la zone de tête (8) et de la zone de pied de pied (9), une zone de transition (11, 18) dont la contraction et l'allongement se trouvent entre la contraction et l'allongement de la zone active (10) et la contraction et l'allongement d'une zone inactive (8, 9) qui est dépourvue d'électrodes.

2. Actionneur multicouche piézocéramique (1) selon la revendication 1, **caractérisé en ce que** dans chaque zone de transition (11) entre la zone active (10) et les zones inactives de tête (8) et de pied (9), la distance (12, 13, 14, 15, 16, 17) qui sépare les électrodes internes (3) augmente d'électrode en électrode quand on va de la zone de tête (8) à la zone de pied (9) de l'actionneur.

3. Actionneur multicouche piézocéramique (1) selon la revendication 1 ou 2, **caractérisé en ce que** l'augmentation de la distance (12, 13, 14, 15, 16, 17) des électrodes internes (3), dans la zone de transition (11) vers la zone de tête (8) ou la zone de pied (9) de l'actionneur (1), en partant de la distance (12) des électrodes (3) dans la zone active (10), s'effectue en croissant successivement chaque fois d'une même quantité.

4. Actionneur multicouche piézocéramique (1) selon la revendication 1 ou 2, **caractérisé en ce que** l'augmentation de la distance (12, 13, 14, 15, 16, 17) des électrodes internes (3), dans la zone de transition (11) vers la zone de tête (8) ou vers la zone de pied (9) de l'actionneur (1), en partant de la distance (12) des électrodes (3) dans la zone active (10), s'effectue en croissant successivement selon une progression géométrique.

5. Actionneur multicouche piézocéramique (1) selon la revendication 1 ou 2, **caractérisé en ce que** l'augmentation de la distance (12, 13, 14, 15, 16, 17) des électrodes internes (3), dans la zone de transition (11) vers la zone de tête (8) ou la zone de pied (9) de l'actionneur (1), en partant de la distance (12) des électrodes (3) dans la zone active (10), s'effectue en croissant selon une progression logarithmique.

6. Actionneur multicouche piézocéramique (1) selon une des revendications 1 à 5, **caractérisé en ce que** le nombre des étapes d'augmentation de la distance (12, 13, 14, 15 16, 17) séparant les électrodes (3) est adapté à la différence de contraction et d'extension qui présentent la zone active (10) et les zones passives (8, 9) qui la bordent.

7. Actionneur multicouche piézocéramique (1) selon une des revendications 1 à 5, **caractérisé en ce que** la plus grande distance (17) séparant les deux dernières électrodes (3) situées dans la zone de transition (11) atteint jusqu'à 2 mm.

8. Actionneur multicouche piézocéramique (1) selon la revendication 6, **caractérisé en ce que** la plus grande distance (17) séparant les deux dernières électrodes (3) situées dans la zone de transition (11) est comprise entre 0,1 mm et 1 mm environ.

9. Actionneur multicouche piézocéramique (1) selon la revendication 1, **caractérisé en ce que** chaque zone de transition (18), aboutissant à la zone de tête inactive (8) et la zone de pied inactive (9), est faite d'une matière piézocéramique modifiée, dont la contraction et l'extension se trouvent entre celles des zones passives et celles de la zone active (10).

10. Actionneur multicouche piézocéramique (1) selon la revendication 9, **caractérisé en ce que** les propriétés de la matière dans la zone de transition (11), notamment son comportement de frittage, peut être influencé par un dopage au moyen d'atomes étrangers des matériaux des électrodes internes (3)

11. Actionneur multicouche piézocéramique (1) selon la revendication 10, **caractérisé en ce que** le dopage de la matière dans la zone de transition (11) a lieu à une concentration qui se règle dans la zone active (10) à la limite entre une électrode interne (3) et la matière céramique (2), par diffusion naturelle.

12. Actionneur multicouche piézocéramique (1) selon la revendication 10 ou 11, **caractérisé en ce que** le dopage de la matière dans la zone de transition (11) est effectué à l'argent.
